Europäisches Patentamt

European Patent Office

Office européen des brevets

(19)

(11)  EP 0 362 779 B1

(12)  EUROPEAN PATENT SPECIFICATION

(45) Date of publication and mention
     of the grant of the patent:
     **20.03.1996  Bulletin 1996/12**

(51) Int Cl.⁶: **H01L 21/76**

(21) Application number: 89118268.5

(22) Date of filing: **02.10.1989**

(54) **Method of forming an isolation region in a semiconductor substrate.**

Verfahren zur Herstellung eines isolierenden Gebiets in einem Halbleitersubstrat.

Procédé de réalisation d'une zone isolante dans un substrat semi-conducteur.

(84) Designated Contracting States:
     **DE FR GB**

(30) Priority: **05.10.1988 JP 251070/88**

(43) Date of publication of application:
     **11.04.1990  Bulletin 1990/15**

(73) Proprietor: **SHARP KABUSHIKI KAISHA
     Osaka (JP)**

(72) Inventors:
  • **Kawamura, Akio
     Nara-shi Nara-ken (JP)**
  • **Iguchi, Katsuji
     Yamatokouriyama-shi Nara-ken (JP)**
  • **Urai, Masahiko
     Nara-shi Nara-ken (JP)**

(74) Representative:
     **TER MEER - MÜLLER - STEINMEISTER &
     PARTNER
     Mauerkircherstrasse 45
     D-81679 München (DE)**

(56) References cited:
  • **IBM Technical Disclosure Bulletin, vol. 23, no.
     11 april 1981, pages 4917-4919, New York US:
     I. ANTIPOV: "Prevention of birdsbeak
     formation"**

## Description

BACKGROUND OF THE INVENTION

The present invention relates to an isolator for electrically isolating semiconductor devices, components of a semiconductor integrated circuit, from each other.

Memory capacities of Very Large Scale Integrations represented by DRAM (Dynamic Random Access Memory), SRAM (Static Random Access Memory), and so on, have been increasing to be four times as large never three years. The DRAMs mainly manufactured at present are of 256 Kb and of 1 Mb. DRAMs of 4 Mb and 16 Mb which will be mainly manufactured in the near future are being studied. It is easily forecast that the DRAMs will progress to have memory capacities of 64 Mb, and then, of 256 Mb.

Such increases in the packing density in a limited chip area have been realized by reduction in size of semiconductor devices consisting a circuit or circuits. For example, the minimum size of MOS transistors used for a 1 Mb DRAM is about 1 $\mu$m at largest at present, and the size will surely be made smaller to 0.5 $\mu$m, and then, to 0.25 $\mu$m. In addition to the reduced size of semiconductor devices, isolation regions positioned between the semiconductor devices on a chip are also related to the realization of the increase in the packing density. Specifically, a reduction of the isolation regions is indispensable to the increase in the packing density, and an isolation width comes to be required to be less than 1 $\mu$m, even to 0.5 $\mu$m at most.

Generally, the isolation regions are constructed of silicon dioxide which is formed in the following way by a selective oxidation method. Unmasked portions of a silicon nitride film covering a silicon substrate are etched away, and then, an exposed surface of the silicon substrate is selectively oxidated, thereby the silicon oxide which serves as an insulator is formed.

The selective oxidation method, however, has revealed the following problems as the semiconductor device regions and the isolation regions therebetween decrease. First, the oxidation of the silicon substrate during the selective oxidation process progresses even to regions covered with the silicon nitride film, and as a result, a silicon dioxide film called a bird's beak spreads. Therefore, there is a limit in the reduction of the isolation regions. Second, a long oxidation process time is required. Because of this, the silicon substrate suffers from stresses, and is flawed. As a result, characteristics of the semiconductor devices fabricated on the substrate deteriorate.

A trench-filling-up isolation method has been proposed as an alternative method of the selective oxidation method having the above problems. This new method consists of forming rectangular trenches in a silicon substrate and filling the trenches up with a silicon oxide layer or other layers. According to this method, only the trench regions are isolation regions serving as isolators. Therefore, the reduction of the isolation regions is possible. In addition, because this method has no thermal process over a long time, deterioration in the substrate characteristics is prevented.

The trench-filling-up method is an isolation method suitable for the fabrication of semiconductor integrated circuits of high packing density. However, this method has the following problems.

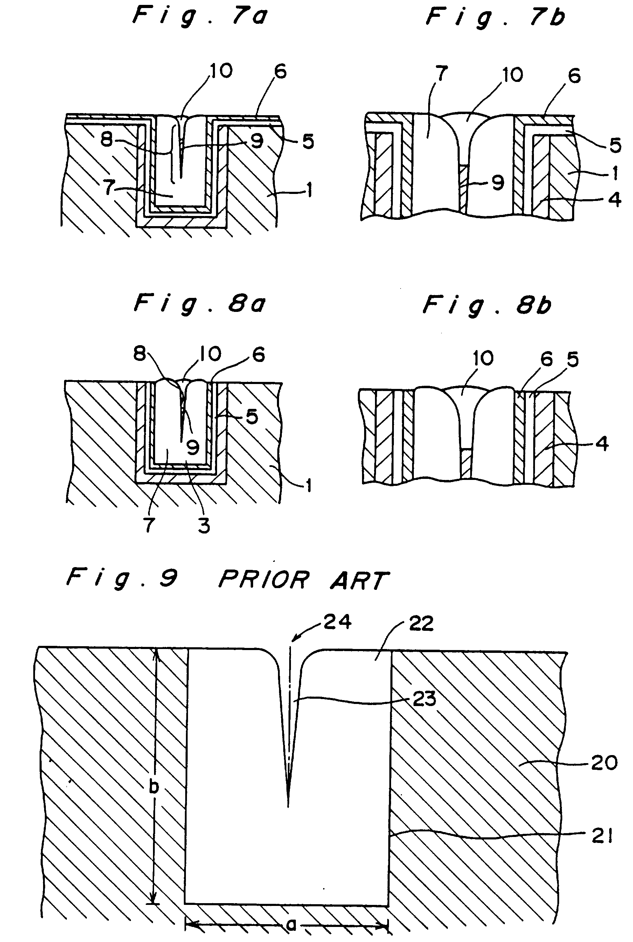

Fig. 9 is a schematic sectional view showing an isolation region formed by the above-described conventional trench-filling-up method. In Fig. 9, a reference numeral 20 designates a silicon substrate on which a trench 21 is formed by a reactive ion etching (RIE) method. A reference numeral 22 is a silicon dioxide layer which fills up the trench 21. The silicon oxide layer 22 is first grown by a CVD (Chemical Vapor Deposition) method and then processed to lead to the state as shown in Fig. 9. Disadvantageously, a very small ditch 23 is generated on the surface of the silicon dioxide layer in the trench 21 for the following reason. The silicon dioxide layer 22 for filling up the trench 21 grows not only on a bottom of the trench 21 but also on the sides thereof at almost same speed. Accordingly, in such a narrow trench as has a width "a" and a depth "b" the relationship between which is given by

$$b > a/2,$$

silicon dioxide layers 22 growing from the opposite sides of the trench 21 collide with each other in the middle of the trench 21 and a junction 24 is formed to the depth of (b-a/2). The union of the silicon oxide layers 22 at the junction 24 is so weak that the silicon dioxide is easily etched along the junction 24 during a rinse process using a dilute hydrofluoric acid which is an indispensable process in the silicon semiconductor fabrication process, thus the small ditch generates.

Generally, formation of a gate insulator film and metalization for a gate electrode wiring for a MOS transistor follow the formation of the isolation regions. At this time, if small ditches exist in the isolation regions, cutting of the wiring takes place. In addition, if wiring materials remain in the small ditch, a short circuit takes place.

IBM Technical Disclosure Bulletin, Vol. 23, No. 11, April 1981, pages 4917 to 4919 discloses an isolator formed by the trench filling method. The small ditches are eliminated by forming narrow slits in the middle of the trenches. Thereafter, a layer of silicon nitride is deposited. If slits are too wide to be refilled with silicon nitride, the refill can be completed by deposition of polysilicon followed by oxidation.

However, the silicon nitride film of the isolation region cannot prevent the bird's beak formation in the oxidation steps of the device fabrication process after completion of the isolation region for the following reason:

In order to fabricate a semiconductor device in an active area, silicon in the active area is required to be exposed. Therefore, the silicon nitride film on the substrate surface in the active area is removed. As a result, the silicon nitride film is left only inside the slits and the CVD silicon oxide is exposed. Generally, in the fabrication process of semiconductor devices, the isolation region formation process is followed by many other oxidation steps. During such oxidation steps, oxygen diffuses in the silicon oxide and even the device-side sidewalls of the trenches are also oxidized, resulting in a lateral expansion of the isolation region.

## SUMMARY OF THE INVENTION

A principal object of the present invention is, therefore, to provide an isolator for isolating semiconductor devices in an integrated circuit, which isolator is suitable for the application to VLSI, wherein the problems inherent in the conventional trench-filling-up method are solved.

The above object is accomplished by a device having the features of the appended claim.

## BRIEF DESCRIPTION OF THE DRAWINGS

The present invention will become more fully understood from the detailed description given hereinbelow and the accompanying drawings which are given by way of illustration only, and thus are not limitative of the present invention, and wherein:

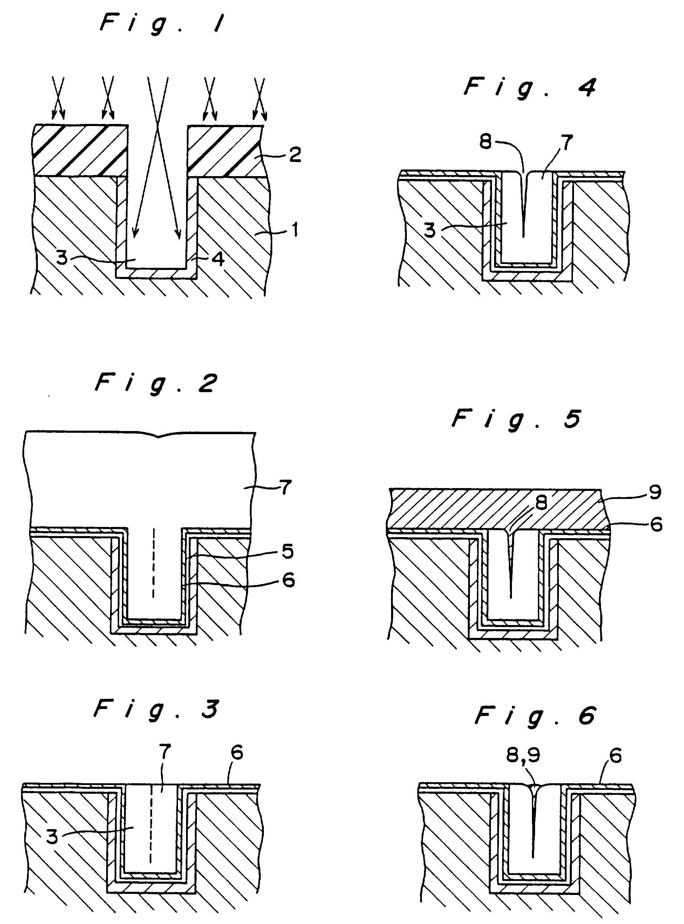

Figs. 1 to 8 illustrate a fabrication process of an isolator as an embodiment of the present invention; and Fig. 9 is an explanatory illustration for showing the problems inherent in the prior art trench-filling-up isolation method.

## DETAILED DESCRIPTION OF THE PREFERRED EMBODIMENT

An embodiment of the present invention will be described in accordance with Figs. 1 to 8 where a fabrication process flow of an isolator of the present embodiment is schematically illustrated. In this embodiment, an electron-beam lithography is used. Needless to say, other technologies can be used for lithography.

Referring to Fig. 1, a reference number 2 designates a resist pattern which has been made by the electron-beam lithography. A p-type silicon substrate 1 is processed in a vertical direction by the RIE method with the resist pattern 2 being used as a mask, so that a trench 3 is etched in the substrate 1. Subsequently, using the resist pattern 2 as a mask, boron ions are obliquely emitted into the trench 3 by an ion implantation technology. In this way, p+ regions 4 are formed on the bottom and sides of the trench 3. This trench 3, which is 0.4 μm wide and 0.6 μm deep in this embodiment, delimits the isolator.

Next, after removing the resist, the top surface of the substrate is thermally oxidized so that a silicon dioxide layer 5 grows 10-50 nm on the walls of the trench 3. Subsequently, silicon nitride is deposited by a pressure-reduction CVD method to form a silicon nitride layer 6 on the order of 30-50 nm. Then, a further silicon dioxide layer 7 on the order of 0.6-1.0 μm is deposited on the silicon nitride layer 6 by a CVD method. A thinner silicon dioxide layer will be enough for the filling of the trench 3, though a wide trench requires a silicon dioxide layer of a thickness larger than a depth of the trench which is a minimum thickness. In order to obtain a smoother surface, it is preferable to form the silicon dioxide layer 7 as thick as possible.

Next, resist (not shown) is spun on the silicon dioxide layer 7, so that an even surface is obtained. After that, the resist and silicon dioxide layer 7 are etched at the same speed by the RIE technique till the silicon nitride layer 6 is exposed. Consequently, a configuration as shown in Fig. 3 is obtained. Then, a remaining thin silicon dioxide film on the silicon nitride layer 6 is removed in a dilute hydrofluoric acid solution. At this time, a small ditch 8 is created on a surface of the silicon dioxide layer 7 in the middle of the trench 3, as shown in Fig. 4. This ditch 8 is filled with a polycrystalline silicon layer 9 which is deposited on the order of 1000-3000 Å (10Å = 1 nm) through the use of the pressure-reduction CVD process, as shown in Fig. 5. Subsequently, etching is performed to remove the polycrystalline silicon layer 9 till the silicon nitride layer 6 is exposed, as shown in Fig. 6. As a result, the polycrystalline silicon 9 remains in the narrow ditch 8 as a filling. Then, the polycrystalline silicon 9 is thermally oxidized at its surface, so that a silicon dioxide larger 10 on the order of 1000-3000 Å is obtained, as shown in Figs. 7a and 7b. At this time, lateral extension of an isolation region, which would be observed with the selective oxidation process, is not observed because the surface of the silicon substrate 1 and the walls of the trench 3 are covered with the silicon nitride layer 6. Some oxidation conditions will cause the polycrystalline silicon 9 to remain on the bottom of the small ditch 8. However, because the remaining polycrystalline silicon 9 is enclosed by the thick silicon dioxide layer 7, it does not cause a short circuit or works as a floating gate, thus never affecting the characteristics of peripheral devices.

Finally, removal of the silicon nitride layer 6 from the silicon substrate 1 through the use of the RIE technique and then removal of the silicon dioxide layer 5 in a dilute hydrofluoric acid solution are performed, as shown in Figs. 8a and 8b. In this way, the formation of the isolator is completed.

Subsequently, devices such as MOS transistors are built in the silicon substrate 1 and fabrication of an integrated circuit or circuits having the built-in devices isolated by the isolators of the above structure is finished.

Actually, MOS transistors (not shown) having a channel length of 0.5 μm were fabricated, electrically isolated by the isolators as narrow as 0.4 μm in width which were fabricated in accordance with the above processes. Measurement of the transistors was made. The measurement result proved that the transistors had better characteristics, i.e., leakage currents were little, for example, as compared with transistors of the same dimensions, but isolated by isolation regions formed by the selective oxidation method. In addition, with respect to leak between devices caused by the parasitic MOS transistor effect, a threshold voltage to the leak was sufficiently high, which competed with transistors isolated by isolation regions formed by the selective oxidation method.

In addition to the above advantages, the isolators of the present embodiment, wherein a small ditch 8 created in the middle of the trench 5 on the silicon oxide layer 7 was filled with silicon 9, which was, in turn, thermally oxidized to form the silicon dioxide layer 10, had the following good effects.

First, further small ditches were not created through the dilute-hydrofluoric-acid treatments posterior to the completion of the isolators. As a result, cutting of the wiring over the isolators and a short circuit were prevented, thus, the yield rate and reliability of semiconductor integrated circuits were very much improved.

Second, because the silicon dioxide layer 10 formed over the trench 3 was obtained by thermally oxidizing the silicon 9 in the ditch, the silicon dioxide layer 10 was reduced very little and maintained a comparatively smooth top surface even after the wafer underwent the fabricating process of a semiconductor integrated circuit. This is because the thermally oxidized silicon has a larger resistance against a hydrofluoric acid solution, as compared with silicon dioxide deposited by the CVD method. The maintenance of a smooth surface of the isolator prevented the wiring from being cut and made a speedy device-fabrication process available and improved productivity.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claim.

## Claims

1. A method of forming an isolator for isolating semiconductor devices in an integrated circuit on a silicon substrate (1) comprising the steps of

   - etching a trench (3) having a predetermined width and depth in said silicon substrate surface, depositing a first CVD silicon dioxide layer (7) on said silicon substrate (1) to fill said trench (3), and carrying out a first etch of said first silicon dioxide layer (7) such that only a portion of said first silicon dioxide layer (7) within said trench (3) remains,
   - carrying out a second etch of said first silicon dioxide layer (7) to form a ditch (8) in the middle of the surface of said portion of silicon dioxide,
   - depositing a polycrystalline silicon layer (9) to fill said ditch (8), and etching said polycrystalline silicon layer (8) so that said polycrystalline silicon layer (8) remains only in said ditch, and

thermally oxidizing the top surface of said polycristalline silicon layer (9) so that a second silicon dioxide layer (10) is obtained,

**characterized by :**

   - growing a further silicon dioxide layer (5) on the surfaces of said trench and said substrate, and depositing a silicon nitride layer (6) on said further silicon dioxide layer (5) prior to the step of depositing said first silicon dioxide layer (7); and
   - during said first etch of said first silicon dioxide layer (7) and said etching of said polycrystalline silicon layer (9), etching said silicon dioxide and said polycrystalline silicon, respectively, until said silicon nitride layer (6) is exposed at said substrate surface.

## Patentansprüche

1. Verfahren zum Herstellen eines Isolators zum Isolieren von Halbleiter-Bauelementen in einer integrierten Schaltung auf einem Halbleitersubstrat (1), mit den folgenden Schritten:

   - Ätzen eines Grabens (3) mit vorgegebener Breite und Tiefe in die Oberfläche des Siliziumsubstrats, Abscheiden einer ersten CVD-Siliziumdioxidschicht (7) auf dem Siliziumsubstrat (1), um den Graben (3) aufzufüllen, und Ausführen eines ersten Ätzvorgangs an der ersten Siliziumdioxidschicht (7) in solcher Weise, daß nur ein Teil dieser ersten Siliziumdioxidschicht (7) innerhalb des Grabens (3) verbleibt;
   - Ausführen eines zweiten Ätzvorgangs an der ersten Siliziumdioxidschicht (7), um eine Senke (8) in der Mitte der Oberfläche dieses Abschnitts aus Siliziumdioxid auszubilden;
   - Abscheiden einer polykristallinen Siliziumschicht (9), um die Senke (8) aufzufüllen, und Ätzen der polykristallinen Siliziumschicht (8) in solcher Weise, daß diese polykristalline Siliziumschicht (8) nur in der Senke zurückbleibt; und
   - thermisches Oxidieren der Oberfläche der polykristallinen Siliziumschicht (9) in solcher Weise, daß eine zweite Siliziumdioxidschicht (10) erhalten wird;

**gekennzeichnet durch**

   - Aufwachsen einer weiteren Siliziumdioxidschicht (5) auf den Oberflächen des Grabens und des Substrats und Abscheiden einer Siliziumnitridschicht (6) auf der weiteren Siliziumdioxidschicht (5) vor dem Schritt des Abscheidens der ersten Siliziumdioxidschicht (7); und

- Ätzen, während des Ätzvorgangs der ersten Siliziumdioxidschicht (7) und des Ätzens der polykristallinen Siliziumschicht (9), dieses Siliziumdioxids bzw. dieses polykristallinen Siliziums, bis die Siliziumnitridschicht (6) an der Substratoberfläche freiliegt.

**Revendications**

1. Procédé pour former un isolateur destiné à isoler des dispositifs semi-conducteurs dans un circuit intégré sur un substrat de silicium (1), comprenant les étapes consistant à:

graver une tranchée (3) ayant une largeur et une profondeur prédéterminées à la surface dudit substrat de silicium, déposer une première couche de dioxyde de silicium de type CVD (7) sur ledit substrat de silicium (1) afin de remplir ladite tranchée (3), et effectuer une première gravure de ladite couche de dioxyde de silicium (7) de telle manière qu'il reste seulement une portion de ladite première couche de dioxyde de silicium (7) à l'intérieur de ladite tranchée (3), effectuer une seconde gravure de ladite première couche de dioxyde de silicium (7) pour former une rainure (8) au milieu de la surface de ladite portion de dioxyde de silicium, déposer une couche de silicium polycristallin (9) pour remplir ladite rainure (8), et graver ladite couche de silicium polycristallin (8) de façon à ce qu'il reste seulement ladite couche de silicium polycristallin (8) dans ladite rainure, et oxyder thermiquement la surface supérieure de ladite couche de silicium polycristallin (9) de façon à obtenir une seconde couche de dioxyde de silicium (10), caractérisé par les étapes consistant à: développer par tirage une autre couche de dioxyde de silicium (5) sur les surfaces de ladite tranchée et dudit substrat, et déposer une couche de nitrure de silicium (6) sur ladite autre couche de dioxyde de silicium (5) avant l'étape de dépôt de ladite première couche de dioxyde de silicium (7), et pendant la première gravure de ladite première couche de dioxyde de silicium (7) et ladite gravure de ladite couche de silicium polycristallin (9), graver ledit dioxyde de silicium et ledit silicium polycristallin, respectivement, jusqu'à ce que ladite couche de nitrure de silicium (6) soit exposée à ladite surface du substrat.

Fig. 1

Fig. 4

Fig. 2

Fig. 5

Fig. 3

Fig. 6

Fig. 7a

Fig. 7b

Fig. 8a

Fig. 8b

Fig. 9 PRIOR ART